# EUROPEAN PATENT APPLICATION

(11) **EP 4 838 245 A1**
(43) Date of publication of application: **11.11.2026**
(21) Application number: 25175087.3
(22) Date of filing: 08.05.2025
(51) Int. Cl.: G01R 33/36

(54) **PHASE SYNCHRONIZED RADIO FREQUENCY TRANSMITTER AND RADIO FREQUENCY RECEIVER**

(71) Applicant: Koninklijke Philips N.V., 5656 AE Eindhoven (NL)
(72) Inventor: VAN HELVOORT, Marinus Johannes Adrianus Maria, Eindhoven (NL); VAN BAKEL, Marcel, Eindhoven (NL)
(74) Representative: Philips Intellectual Property & Standards

(57) **Abstract**

Disclosed is a radio frequency transmitter (102) for a magnetic resonance imaging system (400). The radio frequency transmitter (102) comprises a digital signal generator (110) synchronized to an intermediate clock signal (134) and for generating an intermediate digital transmit signal (124) based on a control signal. The intermediate clock signal (134) is a first integer multiple of a system clock signal (132). The intermediate digital transmit signal (124) has an intermediate frequency. The control signal comprises a frequency offset F1 indicative of a difference between a target frequency of the radio frequency transmit signal and a predetermined resonance frequency F0. The radio frequency transmitter comprises an upconverting digital to analog converter (112) synchronized to a DAC clock signal (136) and configured to generate the radio frequency transmit signal (116) by mixing the intermediate digital transmit signal at the intermediate frequency with a main upconverting signal. The DAC clock signal (136) is synchronized to the intermediate clock signal (132) and the DAC clock frequency and is a second integer multiple of the intermediate clock frequency.

## Description

### FIELD OF THE INVENTION

The invention relates to magnetic resonance imaging, in particular to the radio frequency system of magnetic resonance imaging.

### BACKGROUND OF THE INVENTION

Magnetic Resonance Imaging (MRI) is a non-invasive imaging technique that uses strong magnetic fields and radiofrequency (RF) pulses to generate detailed images of the internal structures of the body. The system operates by aligning hydrogen nuclei within the body using a static magnetic field, then perturbing this alignment with a radio frequency pulse generated by a radio frequency transmitter connected to an RF coil. After the excitation, the nuclei return to equilibrium, emitting RF signals that are detected by a radio frequency receiver connected to an RF coil (which could be the same or different from the transmitting RF coil). These received signals are referred to as k-space data and may be used to reconstruct a magnetic resonance image.

United States patent application US 2010259261 A1 discloses a magnetic resonance imaging radio frequency receiver adapted to receive analogue signals from at least one radio frequency receiver coil unit. The radio frequency receiver comprising: an analogue-digital converter to convert the analogue pre-amplified magnetic resonance signal into a digital signal, means for digital down converting the digital signal and a first communication interface adapted for transmitting the down converted digital signal via a communication link (e.g. wireless, optical or wire-bound).

### SUMMARY OF THE INVENTION

The invention provides a radio frequency transmitter, a radio frequency receiver, a radio frequency system, a magnetic resonance imaging system, a method of generating a radio frequency transmit signal, and a method of receiving k-space data in the independent claims. Embodiments are given in the dependent claims.

In one aspect a radio frequency transmitter for a magnetic resonance imaging system is disclosed. The radio frequency transmitter is configured for providing a radio frequency transmit signal based on a control signal indicative of one or more characteristic properties of the radio frequency transmit signal. The radio frequency transmitter comprises a digital signal generator configured to operate at an intermediate clock frequency of an intermediate clock signal and generate an intermediate digital transmit signal based on the control signal. The intermediate clock signal is synchronized to a system clock signal of the magnetic resonance imaging system and the intermediate clock frequency is a first integer multiple of a system clock frequency of the system clock signal. The intermediate digital transmit signal has an intermediate frequency, and the one or more characteristic properties comprise a frequency offset F1 indicative of a difference between a target frequency of the radio frequency transmit signal and a predetermined resonance frequency F0. The radio frequency transmitter further comprises an upconverting digital to analog converter configured to operate at a DAC clock frequency of a DAC clock signal and generate the radio frequency transmit signal at the target frequency by mixing the intermediate digital transmit signal at the intermediate frequency with a main upconverting signal at a main frequency F_{d}. The DAC clock signal is synchronized to the intermediate clock signal and the DAC clock frequency is a second integer multiple of the intermediate clock frequency.

In another aspect a radio frequency receiver for a magnetic resonance imaging system is disclosed. The radio frequency receiver comprises a down converting analog to digital converter configured to operate at an ADC clock frequency of an ADC clock signal and down convert a radio frequency signal at an initial resonance frequency to an intermediate digital received signal at an intermediate frequency by mixing the radio frequency signal with a main downconverting signal at a main frequency F_{d}. The radio frequency receiver further comprises a digital receiver configured to operate at an intermediate clock frequency of an intermediate clock signal. The digital receiver is configured to down convert the intermediate digital received signal at the intermediate frequency to a final digital received signal at a frequency equal to the initial resonance frequency minus a predetermined resonance frequency by mixing the intermediate digital received signal with a preliminary downconverting signal at a preliminary frequency Fₛ. The intermediate clock signal is synchronized to the system clock signal and the intermediate clock frequency is a first integer multiple of the system clock frequency. The ADC clock signal is synchronized to the intermediate clock signal and the ADC clock frequency is a second integer multiple of the intermediate clock frequency. A sum of the main frequency F_{d} and the preliminary frequency Fₛ is equal to the predetermined resonance frequency F0.

In another aspect a radio frequency system for a magnetic resonance imaging system is disclosed. The radio frequency system comprises an example of the radio frequency transmitter and an example of the radio frequency receiver.

In another example a magnetic resonance imaging system is disclosed. The magnetic resonance imaging system comprises an example of the radio frequency system.

In another aspect a method of generating a radio frequency transmit signal for a magnetic resonance imaging system is disclosed. The method comprises the steps of generating an intermediate digital transmit signal based on a control signal indicative of one or more characteristic properties of the radio frequency transmit signal using a programmable integrated circuit operating at an intermediate clock frequency of an intermediate clock signal and upconverting the intermediate digital transmit signal to the radio frequency transmit signal by a main frequency using an upconverting digital to analog converter operating at a DAC clock frequency of a DAC clock signal. The intermediate clock signal is in synchronization with a system clock signal of the magnetic resonance imaging system and the intermediate clock frequency is a first integer multiple of a system clock frequency of the system clock signal. The one or more characteristic properties comprise a frequency offset F1 indicative of a difference between a target frequency of the radio frequency transmit signal and a predetermined resonance frequency F0, and the intermediate digital transmit signal has an intermediate frequency equal to the frequency offset F1 plus the remainder of the predetermined resonance frequency divided by the system clock frequency. The DAC clock signal is in synchronization with the intermediate clock signal and the DAC clock frequency is a second integer multiple of the intermediate clock frequency. The main frequency is equal to the predetermined resonance frequency minus the remainder of the predetermined resonance frequency divided by the system clock frequency. In another aspect a method of receiving k-space data for a magnetic resonance imaging system is disclosed. The method comprises receiving a radio frequency receive signal at an initial resonance frequency using a digital down converting analog to digital converter. The method further comprises generating an intermediate digital received signal using the digital down converting analog to digital converter by down converting the radio frequency receive signal by a main frequency equal to a predetermined resonance frequency minus the remainder of the predetermined resonance frequency divided by a system clock frequency of the system clock signal. The method further comprises the step of down converting a final digital received signal from the intermediate digital received signal by a preliminary frequency equal to the remainder of the predetermined resonance frequency divided by the system clock frequency using a programmable integrated circuit operating at an intermediate clock frequency of an intermediate clock signal and producing the k-space data based on the final digital received signal. The intermediate clock signal is in synchronization with the system clock signal and the intermediate clock frequency is a first integer multiple of the system clock frequency. The ADC clock signal is in synchronization with the intermediate clock signal and the ADC clock frequency of the ADC clock signal is a second integer multiple of the intermediate clock frequency.

### BRIEF DESCRIPTION OF THE DRAWINGS

In the following preferred embodiments of the invention will be described, by way of example only, and with reference to the drawings in which:
Fig. 1 illustrates an example of a radio frequency system comprising a radio frequency transmitter and a radio frequency receiver for a magnetic resonance imaging system.
Fig. 2 shows a flow chart which illustrates a method of using the radio frequency transmitter illustrated in Fig. 1.
Fig. 3 shows a flow chart which illustrates a method of using the receiver illustrated in Fig. 1.
Fig. 4 illustrates a magnetic resonance imaging system incorporating the radio frequency system of Fig. 1.
Fig. 5 illustrates the incorporation of the magnetic resonance imaging system of Fig. 4 into a cloud based medical imaging system.

### DETAILED DESCRIPTION OF EMBODIMENTS

Like numbered elements in these figures are either equivalent elements or perform the same function. Elements which have been discussed previously will not necessarily be discussed in later figures if the function is equivalent.

In one example a radio frequency transmitter for a magnetic resonance imaging system is disclosed. The radio frequency transmitter is configured for receiving a system clock signal. The system clock signal may be provided by the magnetic resonance imaging system and essentially functions as the timing backbone and coordinates of every aspect of the imaging process by the magnetic resonance imaging system. The pulse sequences for magnetic resonance imaging systems coordinate multiple components and their timing. Achieving high quality imaging from a magnetic resonance imaging system relies on a stable system clock. The intermediate clock signal is a first integer multiple of the system clock signal and configured to be in synchronization with the system clock signal. The DAC clock signal is a second integer multiple of the intermediate clock signal and configured to be in synchronization with the intermediate clock signal. The generation of the DAC clock signal and the intermediate clock signal may for example be performed by a clock device external to the radio frequency transmitter or may be integrated into various components which receive the DAC clock signal and intermediate clock signal, e.g., the exemplary radio frequency transmitter.

The relationship between the different clock signals is: ${M}_{1} * {F}_{SYS} = {F}_{INT} and$ (1) ${M}_{2} * {F}_{INT} = {F}_{DAC} ,$ (2) where *M₁* is the first integer multiple, *M₂* is the second integer multiple, *F_{SYS}* is the system clock frequency of the system clock signal of the MRI system, F_{INT} is the intermediate clock frequency of the intermediate clock signal, and *F_{DAC}* is the DAC clock frequency of the DAC clock signal. Having this integer relationship between the various clock signals may ensure that the phase of the generated clock signals is properly phase locked. The different clock signals could be fed to different components running at different clock rates. For example, there could be a single or programmable integrated circuit running at the intermediate clock signal and an upconverting digital to analog converter running at the DAC clock signal.

The radio frequency transmitter is configured to receive a control signal indicative of one or more characteristic properties of the radio frequency transmit signal. Magnetic resonance imaging is based on the Larmor equation ω0 =γB0 where γ is the gyromagnetic ratio of nucleus and B0 is the strength of the static magnetic field in Tesla (T). When gradient magnetic fields are applied to a subject in a magnetic resonance imaging system of a static B0 field, the resonant frequency of the protons within the body now varies linearly in the three spatial dimensions X, Y, and Z with the strength of the gradient magnetic field. If those protons within a particular slice is to be excited, the radio frequency transmit signal, e.g., in the form of radio frequency pulses with a given center frequency and bandwidth (frequency range), is applied to select that particular slice. Once the particular slice is excited, where in that slice the magnetic resonance signal is coming from is determined by encoding the spatial location with the phase and frequency of the magnetic resonance signal. For excitation of the particular slice, the characteristic properties of the radio frequency transmit signal hereby comprises, but not limited to, an amplitude of the radio frequency transmit signal, a phase of the radio frequency transmit signal, a shape of the radio frequency transmit signal, a frequency offset F1 indicative of a difference between the target center frequency of the radio frequency transmit signal and the predetermined Larmor frequency F0 at the static B0 magnetic field, or combinations thereof. The radio frequency transmitter is configured to provide the radio frequency transmit signal with a frequency bandwidth around the target center frequency for that particular slice.

The radio frequency transmitter comprises a digital signal generator operating at the intermediate clock frequency that is configured to generate an intermediate digital transmit signal based on the control signal. In one embodiment, the intermediate digital transmit signal has an intermediate frequency equal to the frequency offset F1 plus the remainder of the predetermined resonance frequency F0 divided by the system clock frequency. For example, using a 3 Tesla MRI system as an example, the predetermined resonance frequency could be 127.7Mhz according to the Larmor equation. The system clock frequency is 10Mhz. The remainder of the predetermined resonance frequency divided by the system clock frequency (F0/ *F_{SYS}*) is 7.7Mhz. The intermediate frequency is equal to the frequency offset F1 plus 7.7Mhz.

This example represents one set of possible choices for a 3 Tesla MRI system. The values of the various clock signals can be chosen as long as the various digital signals meet the Nyquist criterion. Also, the intermediate frequency may have other choices, e.g., 17.7Mhz, 27.7Mhz or the like as long as the frequency is not too high for the digital signal generator running at the intermediate frequency clock to generate.

The intermediate digital transmit signal may be the digitization of the RF pulse for the magnetic resonance imaging at the intermediate frequency and in digital form. The intermediate digital transmit signal has not yet been converted to an analogue signal.

The radio frequency transmitter further comprises an upconverting digital to analogue converter operating at the DAC clock frequency and for receiving the intermediate digital transmit signal from the digital signal generator. The upconverting digital to analogue converter is configured to generate the radio frequency transmit signal by upconverting the intermediate digital transmit signal by the predetermined resonance frequency minus the intermediate frequency. Using the values from the above example, the intermediate digital transmit signal would be upconverted by a main frequency of 120 Mhz to the target frequency equal to the frequency offset F1 plus 127.7 Mhz.

An upconverting digital to analogue converter is a specialized type of digital to analogue converter that not only converts a digital signal into an analogue signal but also shifts or modulates that signal up to a higher frequency band, so in this example the upconverting digital to analogue converter receives the intermediate digital transmit signal and then upconverts it to the higher target transmit frequency by a main upconverting signal at the main frequency. This radio frequency signal may be connected to the other radio frequency transmit components of a radio frequency system. For example, it may be connected to a matching network that is ultimately connected to a magnetic resonance imaging coil.

This example may be beneficial because it may provide for a radio frequency transmitter that provides a number of advantages. It may provide for reduced requirement on bandwidth between components, have a lower power consumption, may have a lower component cost, may simplify the design and have more reliable timing. In particular the digital signal generator and the upconverting digital to analogue converter are all synchronized to the system clock and will therefore have the correct phase and timing for performing magnetic resonance imaging.

In another example the digital signal generator comprises a modulation controller configured to operate at the system clock frequency and a digital upconverter configured to operate at the intermediate clock frequency. The modulation controller is configured to generate an initial digital signal at an initial frequency equal to the frequency offset F1 based on the control signal. The digital upconverter is configured to upconvert the initial frequency to the intermediate frequency. For example, the digital upconverter mixes the initial digital signal at the initial frequency with a preliminary upconverting signal at a preliminary frequency Fₛ to generate the intermediate digital transmit signal at the intermediate frequency. A sum of the main frequency F_{d} and the preliminary frequency Fₛ is equal to the predetermined resonance frequency F0. This may be beneficial because it provides an extremely accurate and straightforward means of producing the intermediate digital transmit signal.

In another example the digital signal generator is implemented in a single programmable integrated circuit operating at the intermediate clock frequency. The upconverting digital to analog converter is continuously running at the synchronized DAC clock frequency possibly after phase calibration of the magnetic resonance imaging system. As such, control of the one or more characteristic properties of the radio frequency transmit signal may be implemented in the programmable integrated circuit. More particularly, this makes the upconverting digital to analog converter always run in phase with the programmable integrated circuit that implements software control. The preliminary frequency Fₛ, frequency offset F1, phase offset, and amplitude are controlled only in the programmable integrated circuit in a lower speed clock domain. Advantageously, it may require fewer external components (i.e. no complex analogue filters) and may result in lower power consumption which translates into less thermal issues and improved reliability.

In another example the programmable integrated circuit may be an FPGA. The use of an FPGA may be beneficial because it may provide for an inexpensive and energy efficient means of integrating the digital signal generator.

In another example the programmable integrated circuit is an ASIC. For example, a specialized ASIC may be designed to provide an implementation of the digital signal generator. This may also be used to provide for an energy efficient or accurate digital signal generator.

In another example the radio frequency transmitter further comprises a controller configured to operate at the system clock frequency and provide the control signal. The controller is configured to control the modulation controller, which in turn generates the initial digital signal in response to receiving the control signal. The control signal is descriptive of any one of the following: an amplitude of the radio frequency transmit signal, a phase of the radio frequency transmit signal, and a shape of the radio frequency transmit signal, the frequency offset F1 of the radio frequency transmit signal, or combinations thereof. This may for example be implemented as a computational system or processing core which is implemented within the digital signal generator or possibly in an external chip. In some examples, the controller further provides a preliminary control signal indicative of the preliminary frequency Fₛ of the preliminary upconverting signal and/or a main control signal indicative of the main frequency F_{d} of the main upconverting signal. This example may be beneficial because it may provide for an effective means of controlling the radio frequency transmit signal produced by the radio frequency transmitter.

In another aspect a radio frequency receiver for a magnetic resonance imaging system is disclosed. The radio frequency receiver here may work in conjunction with the radio frequency transmitter disclosed above. The radio frequency receiver is configured for operating at an intermediate clock frequency and an ADC clock frequency. As was previously mentioned, the system clock signal may be the system clock of the magnetic resonance imaging system and provides a basis for the timing of the entire magnetic resonance imaging system. The intermediate clock frequency is a first integer multiple of the system clock frequency. The ADC clock frequency is a second integer multiple of the intermediate clock frequency. The radio frequency receiver is configured for receiving a radio frequency signal at an initial resonance frequency. For example, the radio frequency receiver may be set to a resonance frequency equal to the Larmor frequency of a slice excited in a subject for which it is desired to receive k-space data.

The relationship between the different clock signals is (in analogy to Equations (1) and (2)): ${M}_{1} * {F}_{SYS} = {F}_{INT} and$ (3) ${M}_{2} * {F}_{INT} = {F}_{DAC} ,$ (4) where *M₁* is the first integer multiple, *M₂* is the second integer multiple, *F_{SYS}* is the frequency of the system clock of the MRI system, F_{INT} is the intermediate clock frequency of the intermediate clock signal, and *F_{ADC}* is the ADC clock frequency of the ADC clock signal. In many examples the frequency of the ADC clock signal and the DAC clock signal will be the same, although it is not necessary that that is the case.

The radio frequency receiver comprises a digital down converting analogue to digital converter configured to receive the radio frequency signal. A digital down converting analogue to digital converter is a specialized type of analogue to digital converter that receives an analogue signal, in this case the radio frequency signal, and then down converts it and outputs a digital signal. The digital down converting analogue to digital converter is configured to operate at an ADC clock frequency of an ADC clock signal and down convert the radio frequency signal at an initial resonance frequency to an intermediate digital received signal at an intermediate frequency by mixing the radio frequency signal with a main downconverting signal at a main frequency F_{d}. In keeping with the same example that was illustrated for the radio frequency transmitter, the intermediate digital received signal would have a frequency of the frequency offset F1 plus 7.7 Mhz also and would be obtained by down converting the initial resonance frequency equal to the frequency offset F1 plus 127.7 Mhz by 120 Mhz.

The radio frequency receiver further comprises a digital receiver configured to operate at an intermediate clock frequency of an intermediate clock signal. The digital receiver is configured to down convert the intermediate digital received signal at the intermediate frequency to a final digital received signal at a frequency equal to the initial resonance frequency minus a predetermined resonance frequency F0 by mixing the intermediate digital received signal with a preliminary downconverting signal at a preliminary frequency Fₛ. The intermediate clock signal is synchronized to the system clock signal and the intermediate clock frequency is a first integer multiple of the system clock frequency. The ADC clock signal is synchronized to the intermediate clock signal and the ADC clock frequency is a second integer multiple of the intermediate clock frequency. A sum of the main frequency F_{d} and the preliminary frequency Fₛ is equal to the predetermined resonance frequency F0. The final digital received signal at the frequency F1 is further used for generating k-space data. The k-space data is the raw data collected during a magnetic resonance imaging scan before the image reconstruction. The k-space data may be considered to be a mathematical representation of the spatial frequencies and is not directly an image. It is often related to a Fourier transform of the final image. The radio frequency receiver may be beneficial because it may also have the following advantages: a reduction of required bandwidth between components, a lower power consumption, a lower component cost, a simplification of design, and more reliable timing. As was mentioned with the radio frequency transmitter, the relation of the digital down converting analogue to digital converter and the digital receiver directly to the system clock ensures that the measurement of the k-space data is synchronized properly with the system clock.

In another example the digital receiver comprises a demodulation controller configured to operate at the system clock frequency and a digital downconverter configured to operate at the intermediate clock frequency. The digital downconverter is configured for down converting the intermediate digital received signal into the final digital received signal, and the demodulation controller is configured for generating a k-space data based on the final digital received signal.
This may be beneficial because it provides for an effective means of generating the k-space data that is synchronized to the system clock.

In another example, the digital receiver, the digital receiver is implemented in a programmable integrated circuit. The down converting analog to digital converter is continuously running at the synchronized ADC clock signal after phase calibration of the magnetic resonance imaging system and control of phase synchronization of the radio frequency receiver is implemented only in the programmable integrated circuit.

In another example the programmable integrated circuit is implemented as an FPGA. As was previously mentioned, the use of the FPGA may provide for an implementation which is flexibly implemented and also provides for reduced cost and power consumption while maintaining the reliable timing.

In another example the programmable integrated circuit may be an ASIC or a specialized ASIC. The use of an ASIC may provide for an implementation of the demodulation controller and the digital downconverter that are energy efficient and also have highly reliable timing.

In another example a radio frequency system for a magnetic resonance imaging system is disclosed. The radio frequency system may comprise one of the above mentioned radio frequency transmitters and one of the above mentioned radio frequency receivers. This radio frequency system may have the benefits that were previously described to the radio frequency receiver and/or transmitter.

In another example the digital signal generator and the digital receiver are both implemented on a single programmable integrated circuit. In this case the examples where the single or programmable integrated circuit is described for each of the digital signal generator and the digital receiver, this is then the same chip used for implementing both of these. An advantage of doing this is that the intermediate clock signal may be produced and then used for both the digital signal generator and the digital receiver to ensure that the timing is more accurate.

In another example the radio frequency system comprises a control loop that is configured to measure an amplitude and/or phase of the intermediate digital received signal. In some examples the control loop could be implemented in the programmable integrated circuit used to implement the digital signal generator and/or the digital receiver. The control loop is further configured to adjust generation of the intermediate digital transmit signal via the digital upconverter if the amplitude or phase of the intermediate digital received signal is not within the predetermined range. For example, there may be a need to adjust the amplitude and/or phase in order to ensure that the k-space data is measured correctly. The use of the control loop may provide for higher quality k-space measurements and thereby improve magnetic resonance imaging.

In a further example a magnetic resonance imaging system is disclosed. The magnetic resonance imaging system comprises an example of the radio frequency system. The magnetic resonance imaging system may then have a radio frequency system which has lower power consumption, lower component cost, a simplified design, and more reliable timing. This may result in not only a decreased cost of the magnetic resonance imaging system but also an improvement in the quality of magnetic resonance images.

In another aspect a method of generating a radio frequency transmit signal for a magnetic resonance imaging system is disclosed. The method comprises the steps of generating an intermediate digital transmit signal based on a control signal indicative of one or more characteristic properties of the radio frequency transmit signal using a programmable integrated circuit operating at an intermediate clock frequency of an intermediate clock signal and upconverting the intermediate digital transmit signal to the radio frequency transmit signal by a main frequency using an upconverting digital to analog converter operating at a DAC clock frequency of a DAC clock signal. The intermediate clock signal is in synchronization with a system clock signal of the magnetic resonance imaging system and the intermediate clock frequency is a first integer multiple of a system clock frequency of the system clock signal. The one or more properties comprise a frequency offset F1 indicative of a difference between a target frequency of the radio frequency transmit signal and a predetermined resonance frequency F0, and the intermediate digital transmit signal has an intermediate frequency equal to the frequency offset plus the remainder of the predetermined resonance frequency divided by the system clock frequency. The DAC clock signal is in synchronization with the intermediate clock signal and the DAC clock frequency is a second integer multiple of the intermediate clock frequency. The main frequency is equal to the predetermined resonance frequency minus the remainder of the predetermined resonance frequency divided by the system clock frequency. The advantages of this method of generating the radio frequency transmit signal have already been disclosed in the context of the radio frequency transmitter above.

In another aspect a method of receiving k-space data for a magnetic resonance imaging system is disclosed. The method comprises receiving a radio frequency receive signal at an initial reference frequency using a digital down converting analog to digital converter. The method further comprises generating an intermediate digital received signal using the digital down converting analog to digital converter to down convert the radio frequency receive signal by a main frequency equal to a predetermined resonance frequency minus the remainder of the predetermined resonance frequency divided by a system clock frequency of the system clock signal. The method further comprises down converting a final digital received signal from the intermediate digital received signal by a preliminary frequency equal to the remainder of the predetermined resonance frequency divided by the system clock frequency using a programmable integrated circuit operating at an intermediate clock frequency of an intermediate clock signal and producing the k-space data based on the final digital received signal. The intermediate clock signal is in synchronization with the system clock signal, the intermediate clock frequency is a first integer multiple of the system clock frequency. The digital down converting analog to digital converter operates at an ADC clock frequency of an ADC clock signal, the ADC clock signal is in synchronization with the intermediate clock signal and the ADC clock frequency is a second integer multiple of an intermediate clock frequency of the intermediate clock signal. The advantages of the method of receiving the k-space data have been previously discussed in the context of the advantages for the radio frequency receiver.

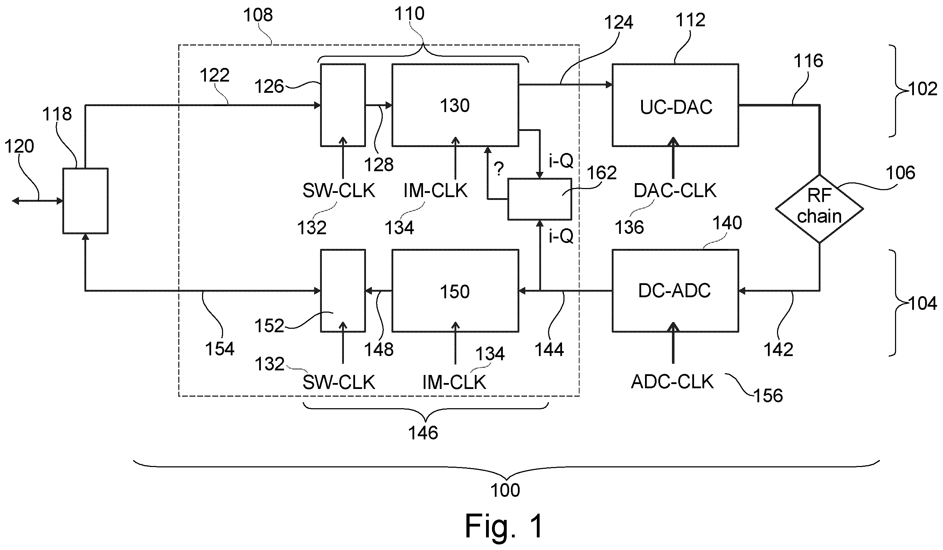

Fig. 1 illustrates an example of a radio frequency system 100. The radio frequency system 100 is shown as comprising a radio frequency transmitter 102 and a separate radio frequency receiver 104. The radio frequency transmitter 102 and the radio frequency receiver 104 are connected to a radio frequency chain 106 of the magnetic resonance imaging system. The radio frequency chain 106 represents the matching networks, antennas and interaction with a subject to produce a magnetic resonance signal.

The radio frequency transmitter 102 is shown as comprising a digital signal generator 110 and an upconverting digital to analogue converter 112. The digital signal generator 110 generates an intermediate digital transmit signal 124 which is then upconverted by the upconverting digital to analogue converter 112 into the radio frequency transmit signal 116 which is fed into the radio frequency chain 106 of the magnetic resonance imaging system. The digital signal generator 110 is shown as optionally comprising a modulation controller 126 and a digital upconverter 130. The optional modulation controller 126 generates an optional initial digital signal 128 which is fed into the digital upconverter 130 to generate the intermediate digital transmit signal 124.

In this particular example the digital signal generator 110 is controlled by an optional controller 118 that has an optional data connection 120 with the magnetic resonance imaging system. Various control signals may be fed to the optional controller 118 and optionally used to control the digital signal generator. The digital signal generator 110 could be part of the transmitter 102 and/or the receiver 104. In other examples the controller 118 is a separate component and may or may not be used to control other components of the magnetic resonance imaging system 400. In some examples, the controller 118 may be coupled to and used to control the digital upconverter 130 and the upconverting digital to analogue converter 112. This may be used to provide the preliminary/main control signals for generating or controlling the preliminary/main upconverting signals, e.g., the preliminary/main frequency information. For example, the upconverting digital to analogue converter 112 may be controlled by the controller 118 to control the frequency of the main upconverting signal. It, for example, may also be used to control the preliminary frequency F_{S} of a preliminary upconverting signal.

In the example of Fig. 1, a control signal 122 descriptive of any one of the following: an amplitude of the radio frequency transmit signal 124, a phase of the radio frequency transmit signal 124, and a shape of the radio frequency transmit signal 124, the frequency offset F1, or combinations thereof, is fed to the modulation controller 126. The frequency offset F1 is indicative of a difference between a target frequency of the radio frequency transmit signal 124 and a predetermined resonance frequency F0. The predetermined resonance frequency F0 is determined according to the Larmor equation ω0 =γB0.

The system clock 132 is used to control the modulation controller 126. The digital upconverter 130 is clocked by an intermediate clock signal 134 and the upconverting digital to analogue converter 112 is clocked using a DAC clock signal 136. The intermediate clock signal 134 may be a first integer multiple of the system clock signal 132 and the DAC clock signal 136 may be a second integer multiple of the system clock signal 132. The components of the radio frequency transmitter 102 are therefore all synchronized and the radio frequency transmitter 102 and be able to effectively and inexpensively generate the radio frequency transmit signal 116 with a greater degree of phase control.

In one example case, it is desired to generate an RF pulse at a target frequency equal to F0 plus F1 (a frequency offset). The predetermined resonance frequency F0 could be chosen to be 127.7 MHz as would be the case for a 3 Tesla MRI system. The modulation controller 126 is controlled to generate an initial digital signal 128 with a frequency of F1. The digital upconverter 130 upconverts the initial digital signal 128 by a preliminary upconverting signal with a frequency of F_{S}. F_{S} could be chosen to be the remainder of the F0 divided by the system clock 132 frequency. With a system clock of 10 MHz, F_{S} would then be 7.7 Mhz. The upconverting digital to analog converter 112 could then upconvert the digital transmit signal 124 by a main frequency F_{d} to F0 + F1 (127.7 MHz + F1). F_{d} could be chosen using the values F_{d} = F₀ - F_{S}. In this example, F_{d} = 120 MHz.

The receiver 104 is shown as comprising a digital down converting analog to digital converter 140 that is connected to a digital receiver 146. The digital down converting analog to digital converter 140 receives a received radio frequency signal 142 from the radio frequency chain 106. The digital down converting analog to digital converter 140 then outputs the intermediate digital received signal 144, which is input into the digital receiver 146. The digital receiver 146 in response outputs the k-space data 154. In this example it is optionally shown as going to the optional controller 118 for transmission along the data connection 120. In this particular example, the digital receiver 146 is shown as optionally comprising digital downconverter 150 and a demodulation controller 152. The demodulation controller 152 is synchronized to the system clock 132 and the digital downconverter 150 is synchronized to the intermediate clock signal 134. The digital down converting analog to digital converter 140 is shown as being synchronized to the analogue to digital converter clock 156.

The digital downconverter 150 receives the intermediate received signal 144 and demodulates it to the final digital received signal 148 which in turn is received by the demodulation controller 152 which produces the k-space data 154.

The digital signal generator 110 and the digital receiver 146 are shown as optionally being implemented on a programmable integrated circuit 108. The programmable integrated circuit could be a single integrated circuit so that the digital signal generator 110 and the digital receiver 146 are implemented on the same chip or integrated circuit. In other examples these components could be implemented on separate and discrete integrated circuits. In another example the digital signal generator 110 is implemented on a first integrated circuit and the digital receiver 146 is implemented on a second integrated circuit. An advantage of using just the single integrated circuit 108 is that the various clock signals 132, 134 can be shared.

The radio frequency system 100 is also shown as optionally comprising a control loop 162. The control loop is able to measure an amplitude and/or phase of the intermediate digital received signal 144. It is then able to adjust the generation of the intermediate digital transmit signal 124 by the digital upconverter 130 if the amplitude and/or phase of the intermediate digital received signal 144 is not within a predetermined range. This may, for example, help to ensure that the quality of the k-space data 154 is improved. This use of this control loop 162 may result in better timing and, as a result, higher quality magnetic resonance images.

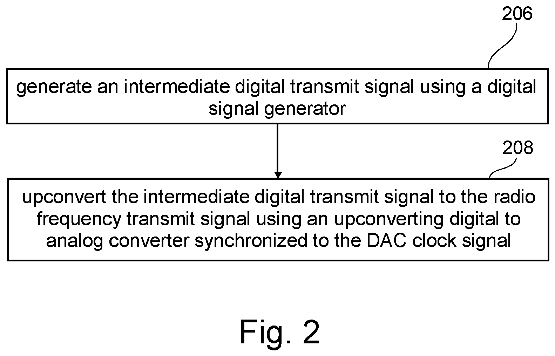

Fig. 2 shows a flowchart which illustrates a method of generating a radio frequency transmit signal 116 for a magnetic resonance imaging system. In 206 an intermediate digital transmit signal 124 is generated based on a control signal indicative of one or more characteristic properties of the radio frequency transmit signal using a programmable integrated circuit 108 operating at an intermediate clock frequency of an intermediate clock signal 134. The intermediate clock signal is in synchronization with a system clock signal 132 of the magnetic resonance imaging system 400 and the intermediate clock frequency is a first integer multiple of a system clock frequency of the system clock signal. The one or more properties comprise a frequency offset F1 indicative of a difference between a target frequency of the radio frequency transmit signal and a predetermined resonance frequency F0. The intermediate digital transmit signal has an intermediate frequency equal to the frequency offset plus the remainder of the predetermined resonance frequency divided by the system clock frequency.

In 208 the intermediate digital transmit signal is upconverted at the intermediate frequency to the radio frequency transmit signal at the target frequency by a main frequency equal to the predetermined resonance frequency minus the remainder of the predetermined resonance frequency divided by the system clock frequency using an upconverting digital to analog converter 112 operating at a DAC clock frequency of a DAC clock signal. The DAC clock signal is in synchronization with the system clock signal and the DAC clock frequency is a second integer multiple of the system clock frequency and the second integer multiple is larger than the first integer multiple.

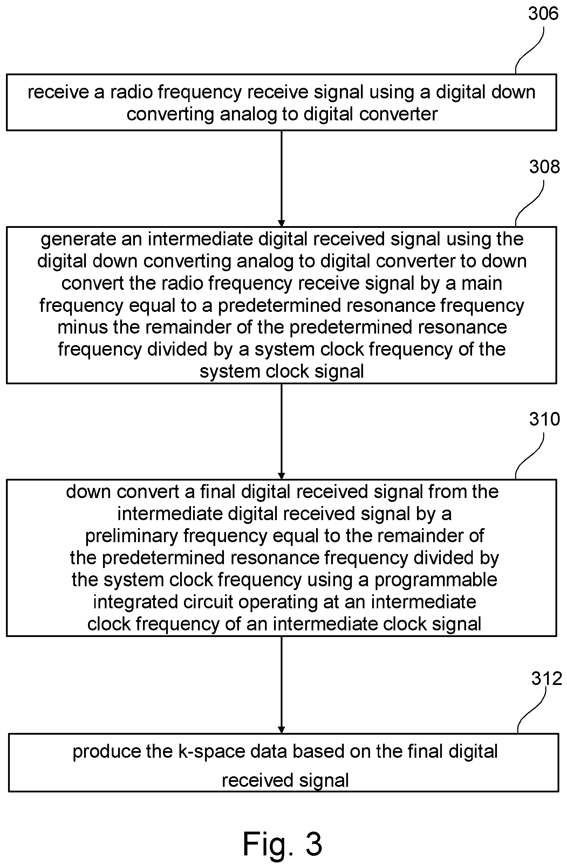

Fig. 3 illustrates a method of receiving k-space data 154 from a magnetic resonance imaging system using the radio frequency receiver 104. In 306 a radio frequency receive signal at an initial reference frequency is received using a digital down converting analog to digital converter 140. The digital down converting analog to digital converter 140 operates at an ADC clock frequency of an ADC clock signal 156 and wherein the ADC clock signal is in synchronization with a system clock signal 132 of the magnetic resonance imaging system 400 and the ADC clock frequency is a second integer multiple of a system clock frequency of the system clock signal.

In 308 an intermediate digital received signal 144 is generated using the digital down converting analog to digital converter to 140 down convert the radio frequency receive signal by a main frequency equal to a predetermined resonance frequency minus the remainder of the predetermined resonance frequency divided by a system clock frequency of the system clock signal.

In 310 a down converting a final digital received signal is down converted from the intermediate digital received signal by a preliminary frequency equal to the remainder of the predetermined resonance frequency divided by the system clock frequency using a programmable integrated circuit operating at an intermediate clock frequency of an intermediate clock signal. The intermediate clock signal is in synchronization with the system clock signal. The intermediate clock frequency is a first integer multiple of the system clock frequency. The second integer multiple is larger than the first integer multiple.

In 312 the k-space data is produced based on the final digital received signal. On a conceptual level, the k-space data may directly be the final digital received signal. However, the data may undergo additional processing. For example, the pulse sequence defines a path through k-space. The path that one defines with the particular magnetic field gradients in the pulse sequence may be off slightly. It is not uncommon to correct the trajectory and adjust the position of the sampled RF signals by accounting for gradient delays and eddy currents. There may be additional digital signal processing applied at this step also, for example a filter may be applied to remove ringing from the samples. If a parallel imaging MRI technique is used there may be multiple coil elements for which data is collected separately and is later combined during the reconstruction of the magnetic resonance image. The acquired k-space data may also have been acquired using a non-Cartesian sampling pattern. Sometimes the final digital received signal may be regridded (resampled) to a Cartesian coordinate system to enable the use of an FFT algorithm for reconstruction of the magnetic resonance image. This type of processing of the final digital received signal could take place during step 312, or it could be delayed to later when the magnetic resonance image is reconstructed.

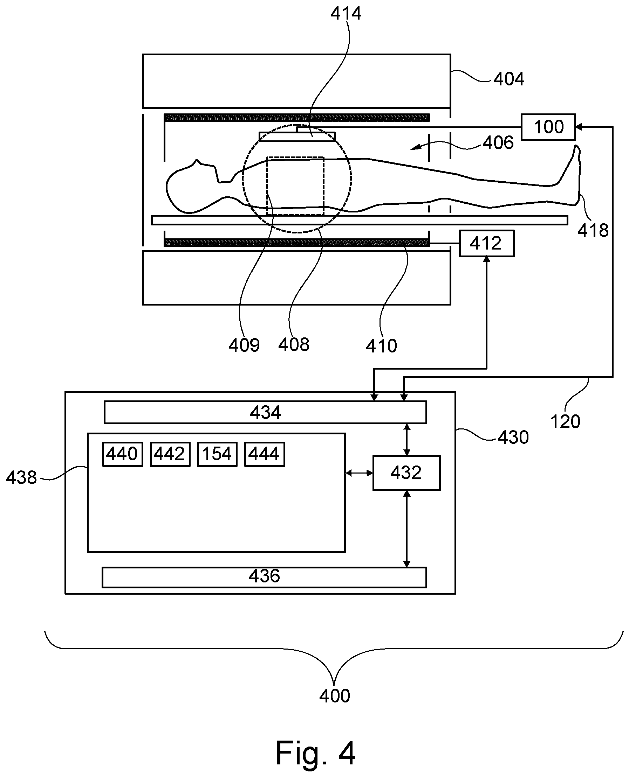

Fig. 4 illustrates a magnetic resonance imaging system 400 that incorporates the radio frequency system 100 of Fig. 1 and a computer 430 or local controller. The magnetic resonance imaging system 400 comprises a magnet 404. The magnet 404 is a superconducting cylindrical type of magnet with a bore 106 through it. It is also possible to use both a split cylindrical magnet and a so-called open magnet. A split cylindrical magnet is similar to a standard cylindrical magnet, except that the cryostat has been split into two sections to allow access to the iso-plane of the magnet. Such magnets may for instance be used in conjunction with charged particle beam therapy. An open magnet has two magnet sections, one above the other with a space in-between that is large enough to receive a subject. The arrangement of the two magnet sections is similar to that of a Helmholtz coil. Open magnets are popular because the subject is less confined. Inside the cryostat of the cylindrical magnet there is a collection of superconducting coils.

Within the bore 406 of the cylindrical magnet 404 there is an imaging zone 408 where the magnetic field is strong and uniform enough to perform magnetic resonance imaging. A field of view 409 is shown within the imaging zone 408. The k-space data are acquired for the field of view 409. The region of interest could be identical with the field of view 409 or it could be a sub volume of the field of view 409. A subject 418 is shown as being supported by a subject support 420 such that at least a portion of the subject 418 is within the imaging zone 408 and the field of view 409.

Within the bore 406 of the magnet there is also a set of magnetic field gradient coils 410 which is used for the acquisition of k-space data to spatially encode magnetic spins within the imaging zone 408 of the magnet 404. The magnetic field gradient coils 410 are connected to a magnetic field gradient coil power supply 412. The magnetic field gradient coils 410 are intended to be representative. Typically, magnetic field gradient coils 410 contain three separate sets of coils for spatial encoding in three orthogonal spatial directions. A magnetic field gradient power supply supplies current to the magnetic field gradient coils. The current supplied to the magnetic field gradient coils 410 is controlled as a function of time and may be ramped or pulsed.

Adjacent to the imaging zone 408 is a radio frequency coil 414 for manipulating the orientations of magnetic spins within the imaging zone 408 and for receiving radio transmissions from spins also within the imaging zone 408. The radio frequency antenna may contain multiple coil elements. The radio frequency antenna may also be referred to as a channel or antenna. The radio frequency coil 414 is connected to a radio frequency system 100 configured as a transceiver. The radio frequency coil 414 and radio frequency system may be replaced by separate transmit and receive coils and a separate transmitter and receiver. It is understood that the radio frequency coil 414 and the radio frequency system 100 are representative. The radio frequency coil 414 is intended to also represent a dedicated transmit antenna and a dedicated receive antenna. Likewise, the transceiver 416 may also represent a separate transmitter and receiver. The radio frequency coil 414 may also have multiple receive/transmit elements and the radio frequency transceiver 416 may have multiple receive/transmit channels.

The computer 430 is intended to represent one or more computers at one or more locations. In this particular example the computer 430 is used to locally control the magnetic resonance imaging system 400. The computer 430 comprises a computational system 432. Various computational tasks may be spread to various processors or computational systems 432 located at one or more locations. The computational system 432 is shown as being in communication with a hardware interface 434 that communicates with the magnetic field gradient coil power supply 412, and the radio frequency system 100. The computational system 432 is able to control the magnetic resonance imaging system 400 via the hardware interface 434. The hardware interface 434 may for example be a network connection and may also enable the communication with other computers or computer systems.

The computational system 432 is shown as being in further communication with an optional user interface 436 that may for example enable an operator or user to control the operation and function of the magnetic resonance imaging system 400. The computational system 432 is in further communication with a memory 438 that is intended to represent various types of memory accessible to the computational system 432. In some examples the memory 438 may be permanent or a non-transitory storage medium.

The memory 438 is shown as containing machine executable instructions 440. The machine executable instructions 140 enable the computational system 132 to function and also to control the magnetic resonance imaging system 102. In some instances, the machine executable instructions 140 may contain an operating system as well as various routines and operations which enable numerical and image processing tasks to be performed.

The memory 438 is further shown as containing pulse sequence commands 442 which may be used to control the magnetic resonance imaging system 400 to acquire the k-space data 154. The memory 438 is optionally shown as containing a magnetic resonance image 444 that was reconstructed from the k-space data 154. The pulse sequence commands 442 also contain commands for controlling the radio frequency system 100. In the configuration shown the radio frequency system 100 is functioning as a transceiver.

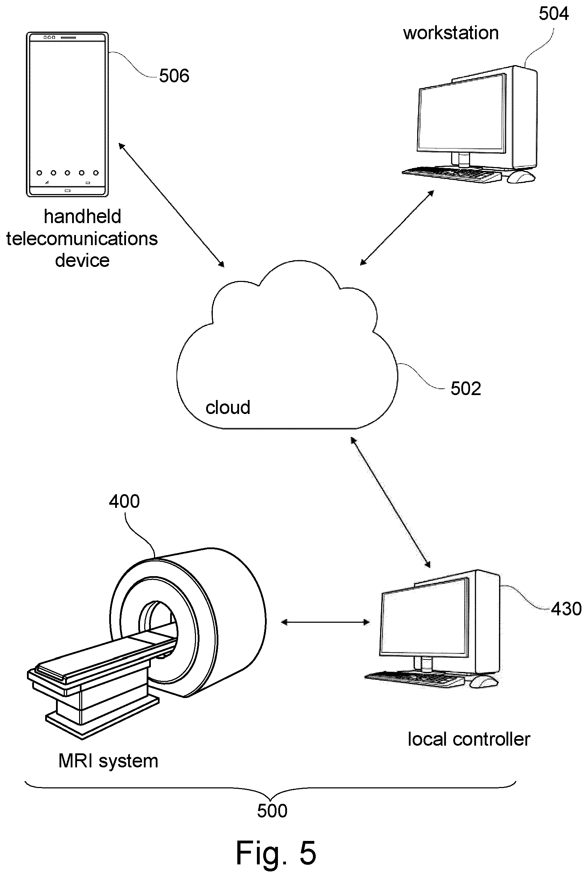

Fig. 5 illustrates an example of a cloud-based medical system 500. In this example there is the magnetic resonance imaging system 400 and the computer 430 functions as a local controller 430 of the magnetic resonance imaging system 400. Instead of performing image reconstruction locally on the computer 430 it is performed in the cloud 502. The local controller 430 is shown as having a network connection to a cloud-based computing system 502. The magnetic resonance image 444 may then be reconstructed in the cloud computing system 502 and then may be redistributed, for example it could be then returned to the computer 430 or it could be forwarded to a workstation 504 or a handheld telecommunication device 506 such as a smartphone or tablet.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit", "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational systems to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the C programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a Local Area Network (LAN) or a Wide Area Network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special-purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, WLAN connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, television screen, touch screen, tactile electronic display, Braille screen, Cathode Ray Tube (CRT), storage tube, bi-stable display, electronic paper, vector display, flat panel display, Vacuum Fluorescent (VD) display, Light-Emitting Diode (LED) displays, Electro-Luminescent Display (ELD), Plasma Display Panels (PDP), Liquid Crystal Display (LCD), Organic Light-Emitting Diode (OLED) displays, a projector, and head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: radio frequency system
- 102: radio frequency transmitter
- 104: radio frequency receiver
- 106: radio frequency chain of MRI system
- 108: single integrated circuit or programmable integrated circuit
- 110: digital signal generator
- 112: upconverting digital to analog converter
- 116: radio frequency transmit signal
- 118: controller
- 120: data connection with MRI system
- 122: control signal
- 124: intermediate digital transmit signal
- 126: modulation controller
- 128: initial digital signal
- 130: digital upconverter
- 132: system clock signal
- 134: intermediate clock signal
- 136: DAC clock signal
- 140: digital down converting analog to digital converter
- 142: radio frequency signal
- 144: intermediate digital received signal
- 146: digital receiver
- 148: final digital received signal
- 150: digital downconverter
- 152: demodulation controller
- 154: k-space data
- 156: ADC clock signal
- 162: control loop
- 206: generate an intermediate digital transmit signal using a digital signal generator
- 208: upconvert the intermediate digital transmit signal to the radio frequency transmit signal using an upconverting digital to analog converter synchronized to the DAC clock signal
- 306: receive a radio frequency receive signal using a digital down converting analog to digital converter
- 308: generate an intermediate digital received signal using the digital down converting analog to digital converter to down convert the radio frequency receive signal by a main frequency equal to a predetermined resonance frequency minus the remainder of the predetermined resonance frequency divided by a system clock frequency of the system clock signal
- 310: down convert a final digital received signal from the intermediate digital received signal by a preliminary frequency equal to the remainder of the predetermined resonance frequency divided by the system clock frequency using a programmable integrated circuit operating at an intermediate clock frequency of an intermediate clock signal
- 312: produce the k-space data based on the final digital received signal
- 400: magnetic resonance imaging system
- 404: magnet
- 406: bore of magnet
- 408: imaging zone
- 409: field of view
- 410: magnetic field gradient coils
- 412: magnetic field gradient coil power supply
- 414: radio frequency coil
- 418: subject
- 420: subject support
- 430: computer
- 432: computational system
- 434: hardware interface
- 436: optional user interface
- 438: memory
- 440: machine executable instructions
- 442: pulse sequence commands
- 444: magnetic resonance image
- 500: medical imaging system
- 502: cloud computing system
- 504: workstation
- 506: handheld telecommunications device

## Claims

1. A radio frequency transmitter (102) for a magnetic resonance imaging system (400), wherein the radio frequency transmitter (102) is configured for providing a radio frequency transmit signal (116) based on a control signal indicative of one or more characteristic properties of the radio frequency transmit signal (116), wherein the radio frequency transmitter (102) comprises:
- a digital signal generator (110) configured to operate at an intermediate clock frequency of an intermediate clock signal (134) and generate an intermediate digital transmit signal (124) based on the control signal, wherein the intermediate clock signal (134) is synchronized to a system clock signal (132) of the magnetic resonance imaging system and the intermediate clock frequency is a first integer multiple of a system clock frequency of the system clock signal (132) and wherein the intermediate digital transmit signal (124) has an intermediate frequency, and wherein the one or more properties comprise a frequency offset F1 indicative of a difference between a target frequency of the radio frequency transmit signal and a predetermined resonance frequency F0;
- an upconverting digital to analog converter (112) configured to operate at a DAC clock frequency of a DAC clock signal (136) and generate the radio frequency transmit signal (116) at the target frequency by mixing the intermediate digital transmit signal at the intermediate frequency with a main upconverting signal at a main frequency F_{d}, wherein the DAC clock signal (136) is synchronized to the intermediate clock signal (134) and the DAC clock frequency is a second integer multiple of the intermediate clock frequency.

2. The radio frequency transmitter of claim 1, wherein the digital signal generator (110) comprises a modulation controller (126) configured to operate at the system clock frequency and a digital upconverter (130) configured to operate at the intermediate clock frequency, wherein the modulation controller (126) is configured to generate an initial digital signal (128) at an initial frequency equal to the frequency offset F1 based on the control signal, and wherein the digital upconverter (130) is configured to mix the initial digital signal (128) at the initial frequency with a preliminary upconverting signal at a preliminary frequency Fₛ to generate the intermediate digital transmit signal (124) at the intermediate frequency, and wherein a sum of the main frequency F_{d} and the preliminary frequency Fₛ is equal to the predetermined resonance frequency F0.

3. The radio frequency transmitter of claim 2, wherein the radio frequency transmitter further comprises a controller (118) configured to operate at the system clock frequency and provide the control signal, and wherein the controller is configured to control the modulation controller to generate the initial digital signal in response to receiving the control signal, wherein the control signal is descriptive of any one of the following: an amplitude of the initial digital signal, a phase of the initial digital signal, and a shape of the initial digital signal, the frequency of the initial digital signal, and combinations thereof.

4. The radio frequency transmitter of claim 1, 2, or 3, wherein the digital signal generator is implemented in a programmable integrated circuit (108), and wherein the upconverting digital to analog converter is continuously running at the synchronized DAC clock signal after phase calibration of the magnetic resonance imaging system and wherein control of the one or more characteristic properties of the radio frequency transmit signal is implemented only in the programmable integrated circuit.

5. The radio frequency transmitter of claim 4, wherein the programmable integrated circuit is an FPGA or an ASIC.

6. A radio frequency receiver (104) for a magnetic resonance imaging system (400) comprising:
- a down converting analog to digital converter (140) configured to operate at an ADC clock frequency of an ADC clock signal and down convert a radio frequency signal (142) at an initial resonance frequency to an intermediate digital received signal (144) at an intermediate frequency by mixing the radio frequency signal (142) with a main downconverting signal at a main frequency F_{d}; and
- a digital receiver (146) configured to operate at an intermediate clock frequency of an intermediate clock signal, wherein the digital receiver is configured to down convert the intermediate digital received signal at the intermediate frequency to a final digital received signal (148) at a frequency F1 equal to the initial resonance frequency minus a predetermined resonance frequency F0 by mixing the intermediate digital received signal with a preliminary downconverting signal at a preliminary frequency Fₛ, wherein the intermediate clock signal (134) is synchronized to a system clock signal (132) and the intermediate clock frequency is a first integer multiple of the system clock frequency, wherein the ADC clock signal is synchronized to the intermediate clock signal of the magnetic resonance imaging system, and the ADC clock frequency is a second integer multiple of the intermediate clock frequency, and wherein a sum of the main frequency F_{d} and the preliminary frequency Fₛ is equal to the predetermined resonance frequency F0.

7. The radio frequency receiver of claim 6, wherein the digital receiver comprises a demodulation controller (152) configured to operate at the system clock frequency and a digital downconverter (150) configured to operate at the intermediate clock frequency, wherein the digital downconverter (150) is configured for down converting the intermediate digital received signal into the final digital received signal, and wherein the demodulation controller (152) is configured for generating k-space data (154) based on the final digital received signal (148).

8. The radio frequency receiver of claim 7, wherein the digital receiver is implemented in a programmable integrated circuit (108), and wherein the down converting analog to digital converter is continuously running at the synchronized ADC clock signal after phase calibration of the magnetic resonance imaging system and wherein control of phase synchronization of the radio frequency receiver is implemented only in the programmable integrated circuit.

9. The radio frequency receiver of claim 8, wherein the programmable integrated circuit is an FPGA or an ASIC.

10. A radio frequency system (100) for a magnetic resonance imaging system comprising the radio frequency transmitter (102) of any one of claims 1 through 5 and the radio frequency receiver (104) of any one of claims 6 through 9.

11. The radio frequency system of claim 10, wherein a preliminary frequency of the radio frequency transmitter and/or the radio frequency receiver is a remainder of the predetermined resonance frequency divided by the system clock frequency, and wherein the main frequency of the radio frequency transmitter and/or the radio frequency receiver divided by the system clock frequency is an integer.

12. The radio frequency system of claim 11, wherein the radiofrequency system comprises a control loop (162) configured to:
- measure an amplitude and/or phase of the intermediate digital received signal (144) ; and
- adjust generation of the intermediate digital transmit signal (124) by the digital signal generator if the amplitude and/or the phase of the intermediate digital received signal (144) is not within a predetermined range.

13. A magnetic resonance imaging system (400) comprising the radio frequency system (100) of claim 10, 11, or 12.

14. A method of generating a radio frequency transmit signal (116) for a magnetic resonance imaging system (400), wherein the method comprises:
- generating (206) an intermediate digital transmit signal (124) based on a control signal indicative of one or more characteristic properties of the radio frequency transmit signal using a programmable integrated circuit (108) operating at an intermediate clock frequency of an intermediate clock signal, wherein the intermediate clock signal is in synchronization with a system clock signal of the magnetic resonance imaging system and the intermediate clock frequency is a first integer multiple of a system clock frequency of the system clock signal, and wherein the one or more properties comprise a frequency offset F1 indicative of a difference between a target frequency of the radio frequency transmit signal and a predetermined resonance frequency F0, and the intermediate digital transmit signal has an intermediate frequency equal to the frequency offset plus the remainder of the predetermined resonance frequency divided by the system clock frequency; and
- upconverting (208) the intermediate digital transmit signal at the intermediate frequency to the radio frequency transmit signal at the target frequency by a main frequency equal to the predetermined resonance frequency minus the remainder of the predetermined resonance frequency divided by the system clock frequency using an upconverting digital to analog converter (112) operating at a DAC clock frequency of a DAC clock signal, wherein the DAC clock signal is in synchronization with the intermediate clock signal and the DAC clock frequency is a second integer multiple of the intermediate clock frequency.

15. A method of receiving k-space data (154) for a magnetic resonance imaging system (400), wherein the method comprises:
- receiving (306) a radio frequency receive signal at an initial resonance frequency using a digital down converting analog to digital converter (150), wherein the digital down converting analog to digital converter operates at an ADC clock frequency of an ADC clock signal (156);
- generating (308) an intermediate digital received signal (144) using the digital down converting analog to digital converter to down convert the radio frequency receive signal by a main frequency equal to a predetermined resonance frequency minus the remainder of the predetermined resonance frequency divided by a system clock frequency of the system clock signal;
- down converting (310) a final digital received signal (148) from the intermediate digital received signal by a preliminary frequency equal to the remainder of the predetermined resonance frequency divided by the system clock frequency using a programmable integrated circuit operating at an intermediate clock frequency of an intermediate clock signal, wherein the intermediate clock signal is in synchronization with the system clock signal, the intermediate clock frequency is a first integer multiple of the system clock frequency, and wherein the ADC clock signal is in synchronization with the intermediate clock signal and the ADC clock frequency is a second integer multiple of the intermediate clock frequency of the intermediate clock signal; and
- producing (312) the k-space data based on the final digital received signal.
